(19) Europäisches Patentamt

European Patent Office

Office européen des brevets

(11) **EP 1 085 582 A2**

(12) **EUROPEAN PATENT APPLICATION**

(43) Date of publication:
21.03.2001 Bulletin 2001/12

(51) Int. Cl.[7]: **H01L 33/00**, H01S 5/343

(21) Application number: 00118584.2

(22) Date of filing: 25.08.2000

(84) Designated Contracting States:
**AT BE CH CY DE DK ES FI FR GB GR IE IT LI LU MC NL PT SE**
Designated Extension States:
**AL LT LV MK RO SI**

(30) Priority: 27.08.1999 JP 24164599

(71) Applicant:
**Canare Electric Co., Ltd.
Aichi-gun, Aichi-ken 480-1101 (JP)**

(72) Inventor: **Kano, Hiroyuki
Nishikamo-gun, Aichi-ken 470-0201 (JP)**

(74) Representative:
**Leson, Thomas Johannes Alois, Dipl.-Ing. et al
Patentanwälte
Tiedtke-Bühling-Kinne & Partner,
Bavariaring 4
80336 München (DE)**

(54) **Light-emitting semiconductor device with quantum-wave interference layers**

(57)     A light-emitting diode 100 comprises an emission layer with a multiple quantum well (MQW) structure and a quantum-wave interference layer having plural periods of a pair of a first layer and a second layers, and the second layer having a wider band gap than said first layer. A band gap energy of a well layer in the emission layer is smaller than that of any other component layers in the quantum-wave interference layer. As a result, a luminous intensity of the light-emitting diode 100 improved 50% compared with a conventional light-emitting diode.

**FIG. 8**

EP 1 085 582 A2

**Description**

BACKGROUND OF THE INVENTION

Field of the invention

The present invention relates to a semiconductor device with a quantum-wave interference layer which reflects carriers, i.e., electrons or holes, effectively. The present invention also relates to a semiconductor device with a quantum-wave interference layer which transmits carriers, i.e., electrons or holes, effectively. Especially, the present invention relates to a light-emitting device such as a laser or a light-emitting diode in which recombination of carriers, or electrons and holes, occurs effectively in an active layer and luminous efficiency of the device is improved.

Description of the Related Art

A semiconductor device has been known to have a double hetero junction structure whose active layer is formed between n-type and p-type cladding layers. The cladding layers function as potential barriers for effectively confining carriers, or electrons and holes, within the active layer.

However, a problem persists in luminous efficiency. Carriers overflow the potential barriers of the cladding layers, which lowers luminous efficiency. Therefore, further improvement has been required, as presently appreciated by the present inventors.

As a countermeasure, forming cladding layers having a multiple quantum well structure of a first and a second layer as a unit in a laser diode in order to reflect carriers has been suggested by Takagi et al. (Japanese Journal of Applied Physics. Vol. 29, No.11, November 1990, pp.L1977-L1980). This reference, however, does not teach or suggest values of kinetic energy of carriers to be considered.

SUMMARY OF THE INVENTION

The inventor of the present invention conducted a series of experiments and found that, although it can be understood that Takagi et al. used a band gap energy alternative to a kinetic energy, the suggested thickness of the first and the second layers by Takagi et al. were too small to confine electrons, and that preferable thicknesses of the first and second layers are 4 to 6 times larger than those suggested by Takagi et al. So a problem still persisted in inadequacy of reflecting carriers.

Further, the present inventor thought that multiple quantum-wave reflection of carriers might occur by a multiple layer structure with different band width, like multiple light reflection by a dielectric multi-film structure. And the inventor thought that it would be possible to confine carriers by the reflection of the quantum-wave interference layer and filed an application with respect to this (Japanese Patent Application laid-open No. H10-303406).

Then the inventor of the present invention concerned a characteristic of electrons as a wave and considered that the quantum-wave interference layer functions as a transmission layer of carriers, by analogy with the multiple reflection of the light. That is, when each thickness of layers in the multiple layer structure is about an order of the wavelength of a quantum-wave of carriers, an interference effect of quantum-wave is considered to occur with respect to a conduction of carriers in the multiple layer structure. The interference effect caused a conduction as a wave. Accordingly, the inventor of the present invention considered that not a conduction of particle in a classical theory but a resonance of waves, an interference, or other phenomenon is occurred by an interference effect of electrons. This wave behavioral characteristic of electrons improves a mobility and a propagation velocity.

Accordingly, a luminous efficiency of a light-emitting device having a cladding layer in which multiple quantum well barrier or multiple layers such as quantum-wave interference layers in the present invention are formed should be improved.

It is, therefore, a first object of the present invention is to improve a luminous efficiency of a light-emitting semiconductor device having a quantum-wave interference layer of high reflectivity with a multiple layer structure which functions as a reflection layer of carriers or a quantum-wave interference layer of high transmittivity and high mobility with a multiple layer structure which functions as a transmission layer of carriers.

In light of these objects a first aspect of the present invention is a light-emitting semiconductor device comprising an emission layer with a single layer structure and at least one quantum-wave interference layer. The quantum-wave interference layer has plural periods of a pair of a first layer and a second layer, and the second layer has a wider band gap than the first layer. A band gap of a conduction band and a valence band of the emission layer is smaller than those of any other component layers formed in the quantum-wave interference layer.

A second aspect of the present invention is a light-emitting semiconductor device comprising an emission layer with a single quantum well (SQW) structure as a well layer or a multiple quantum well (MQW) structure having plural pairs of a well layer and a barrier layer, and at least one quantum-wave interference layer. The quantum-wave interference layer has plural periods of a pair of a first layer and a second layer, and the second layer has a wider band gap than the first layer. A band gap of a conduction band and a valence band of the emission layer is smaller than those of any other component layers formed in the quantum-wave interference layer.

A third aspect of the present invention is the light-emitting semiconductor device comprising at least one of the quantum-wave interference layer. Each thickness of the first and the second layers in the quantum-wave interference layer is determined by multiplying by an odd number one fourth of a quantum-wave wavelength of carriers in each of the first and the second layers.

A fourth aspect of the present invention is to define each thickness of the first and the second layers as follows:

$$D_{RW} = n_{RW}\lambda_{RW}/4 = n_{RW}h/4[2m_{RW}(E_R+V_R)]^{\frac{1}{2}} \qquad (1\text{-}1)$$

and

$$D_{RB} = n_{RB}\lambda_{RB}/4 = n_{RB}h/4(2m_{RB}E_R)^{\frac{1}{2}} \qquad (1\text{-}2)$$

In Eqs. 1-1 and 1-2, h, $m_{RW}$, $m_{RB}$, $E_R$, $V_R$, and $n_{RW}$, $n_{RB}$ represent Plank's constant, the effective mass of carriers in the first layer, the effective mass of carriers in the second layer, the kinetic energy of the carriers at the level near the lowest energy level of the second layer, the potential energy of the second layer relative to the first layer, and odd numbers, respectively. Carriers injected into the second layer are preferably existing around the lowest energy of the second layer.

A fifth aspect of the present invention is a first quantum-wave interference layer having a plurality of partial quantum-wave interference layers $I_{Rk}$ with arbitrary periods $T_{Rk}$ including a first layer having a thickness of $D_{RWk}$ and a second layer having a thickness of $D_{RBk}$ and arranged in series. The thicknesses of the first and the second layers satisfy the formulas:

$$D_{RWk} = n_{RWk}\lambda_{RWk}/4 = n_{RWk}h/4[2m_{RWk}(E_{Rk}+V_R)]^{\frac{1}{2}} \qquad (2\text{-}1)$$

and

$$D_{RBk} = n_{RBk}\lambda_{RBk}/4 = n_{RBk}h/4(2m_{RBk}E_{Rk})^{\frac{1}{2}} \qquad (2\text{-}2)$$

In Eqs. 2-1 and 2-2, $E_{Rk}$, $m_{RWk}$, $m_{RBk}$, and $n_{RWk}$, $n_{RBk}$ represent plural kinetic energy levels of carriers flowing into the second layer, effective mass of carriers with kinetic energy $E_{Rk}+V_R$ in the first layer, effective mass of carriers with kinetic energy $E_{Rk}$ in the second layer, and arbitrary odd numbers, respectively.

The plurality of the partial quantum-wave interference layers $I_{Rk}$ are arranged in series from $I_{R1}$ to $I_{Rj}$, where j is a maximum number of k required to from a quantum-wave interference layer as a whole.

A sixth aspect of the present invention is a semiconductor device having a quantum-wave interference layer with a plurality of partial quantum-wave interference layers arranged in series with arbitrary periods. Each of the plurality of partial quantum-wave interference layers is constructed with serial pairs of the first and second layers. The widths of the first and second layers of the serial parts are represented by $(D_{RB1}, D_{RW1})$, ..., $(D_{RBk}, D_{RWk})$, ..., $(D_{RBj}, D_{RWj})$. $(D_{RBk}, D_{RWk})$ is a pair of widths of the first and second layers and is defined as Eqs 2-1 and 2-2, respectively.

A seventh aspect of the present invention is to form a $\delta_R$ layer, which varies an energy band sharply, at an interface between the first and the second layers. A thickness of the $\delta_R$ layer is substantially thinner than that of the first and the second layers.

An eighth aspect of the present invention is to provide a quantum-wave interference layer which functions as a reflection layer of carriers.

A ninth aspect of the present invention is to constitute a quantum-wave incident facet in the quantum-wave interference layer by a second layer with enough thickness for preventing conduction of carriers by a tunneling effect.

Alternatively, the present invention can be applied to a quantum-wave interference layer having other composition. A tenth aspect of the present invention is the light-emitting semiconductor device comprising at least one quantum-wave interference layer. Each thickness of the first and the second layers in the quantum-wave interference layer is determined by multiplying by an even number one fourth of a quantum-wave wavelength of carriers in each of the first and the second layers.

A eleventh aspect of the present invention is to define each thickness of the first and the second layers as follows:

$$D_{TW} = n_{TW}\lambda_{TW}/4 = n_{TW}h/4[2m_{TW}(E_T+V_T)]^{\frac{1}{2}} \qquad (3\text{-}1)$$

and

$$D_{TB} = n_{TB}\lambda_{TB}/4 = n_{TB}h/4(2m_{TB}E_T)^{\frac{1}{2}} \qquad (3\text{-}2)$$

In Eqs. 3-1 and 3-2, h, $m_{TW}$, $m_{TB}$, $E_T$, $V_T$, and $n_{TW}$, $n_{TB}$ represent Plank's constant, the effective mass of carriers in the first layer, the effective mass of carriers in the second layer, the kinetic energy of the carriers at the level near the lowest energy level of the second layer, the potential energy of the second layer relative to the first layer, and even numbers, respectively. Carriers injected into the second layer are preferably existing around the lowest energy of the second layer.

A twelfth aspect of the present invention is the quantum-wave interference layer having a plurality of partial quantum-wave interference layers $I_{Rk}$ with arbitrary periods $T_{Tk}$ including a first layer having a thickness of $D_{TWk}$ and a second layer having a thickness of $D_{TBk}$ and arranged in series. The thicknesses of the first and the second layers satisfy the formulas:

$$D_{TWk} = n_{TWk}\lambda_{TWk}/4 = n_{TWk}h/4[2m_{TWk}(E_{Tk}+V_T)]^{\frac{1}{2}} \qquad (4\text{-}1)$$

and

$$D_{TWk} = n_{TWk}\lambda_{TBk}/4 = n_{TBk}h/4(2m_{TBk}E_{Tk})^{\frac{1}{2}} \qquad (4\text{-}2)$$

In Eqs. 4-1 and 4-2, $E_{Tk}$, $m_{TWk}$, $m_{TBk}$, and $n_{TWk}$, $n_{TBk}$ represent plural kinetic energy levels of carriers flowing into the second layer, effective mass of carriers with kinetic energy $E_{Tk}+V_T$ in the first layer, effective mass of carriers with kinetic energy $E_{Tk}$ in the second layer, and arbitrary even numbers, respectively.

The plurality of the partial quantum-wave interference layers $I_{Tk}$ are arranged in series from $I_{T1}$ to $I_{Tj}$, where j is a maximum number of k required to from a quantum-wave interference layer as a whole.

A thirteenth aspect of the present invention is a semiconductor device having a quantum-wave interference layer with a plurality of partial quantum-wave interference layers arranged in series with arbitrary periods. Each of the plurality of partial quantum-wave interference layers is constructed with serial pairs of the first and second layers. The widths of the first and second layers of the serial parts are represented by $(D_{TB1}, D_{TW1})$, ..., $(D_{TBk}, D_{TWk})$, ...,$(D_{TBj}, D_{TWj})$. $(D_{TBk}, D_{TWk})$ is a pair of widths of the first and second layers and is defined as Eqs 4-1 and 4-2, respectively.

A fourteenth aspect of the present invention is to form a $\delta_T$ layer, which varies an energy band sharply, at an interval between the first and the second layers. A thickness of the $\delta_T$ layer is substantially thinner than that of the first and the second layers.

An fifteenth aspect of the present invention is to provide a quantum-wave interference layer which functions as a transmission layer of carriers.

(First and second aspects of the present invention)

The inventor of the present invention has already invented several inventions and filed patent applications with respect to quantum-wave interference layer having various compositions. A quantum-wave interference layer comprising an emission layer is disclosed in, for example, Japanese Patent Application laid-open No. H10-303406. Such a light-emitting semiconductor device comprises at least one quantum-wave interference layer, which has plural periods of a pair of a first layer and a second layer having a wider band gap than the first layer. The light-emitting semiconductor device also comprises an emission layer with a single layer structure, with a single quantum well (SQW) structure as a well layer or with a multiple quantum well (MQW) structure having plural pairs of a well layer and a barrier layer. A band gap energy of the emission layer is smaller than those of any component layers in the quantum-wave interference layer. As a result, electrons and holes are easily accumulated in the emission layer or in the well layer which is formed in the emission layer, resulting in forming electron-hole pairs and improving luminous efficiency.

(Third, fourth and eighth aspects of the present invention)

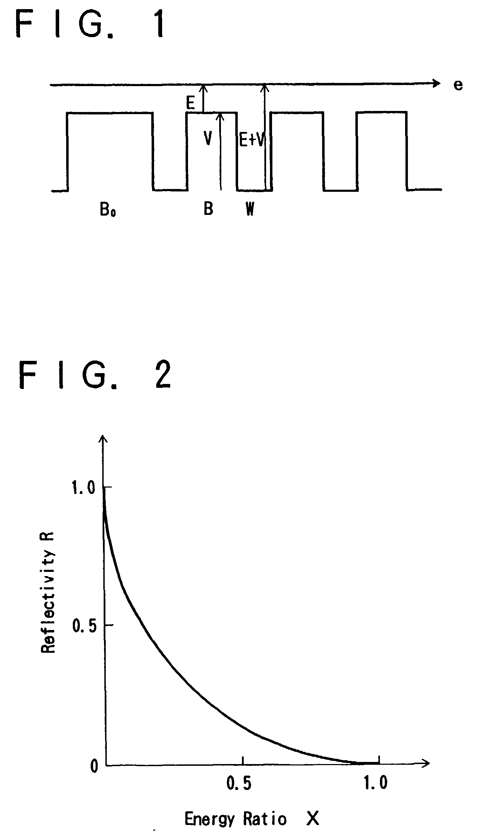

The principle of the first kind of quantum-wave interference layer of the present invention is explained hereinafter. FIG. 1 shows a conduction band of a multiple layer structure with plural periods of a first layer W and a second layer B as a unit. A band gap of the second layer B is wider than that of the first layer W. Electrons conduct from left to right as shown by an arrow in FIG. 1. Among the electrons, those that exist at the level near the lowest energy level of a conduction band in the second layer B are most likely to contribute to conduction. The electrons near the bottom of conduction band of the second layer B has a kinetic energy E. Accordingly, the electrons in the first layer W have a kinetic energy E+V which is accelerated by potential energy V due to the band gap between the first layer W and the second layer B. In other words, electrons that move from the first layer W to the second layer B are decelerated by potential energy V and return to the original kinetic energy E in the second layer B. As explained above, kinetic energy of electrons in the conduction band is modulated by potential energy due to the multiple layer structure.

When thicknesses of the first layer W and the second layer B are equal to order of quantum-wave wavelength, electrons tend to have characteristics of a wave. The wave length of the electron quantum-wave is calculated by Eqs. 1-1 and 1-2 using kinetic energy of the electron. Further, defining the respective wave number vector of first layer W and second layer B as $K_W$ and $K_B$, reflectivity R of the wave is calculated by:

$$R = (|K_W|-|K_B|) / (K_W|+|K_B|) \tag{5}.$$
$$= [\{m_W(E+V)\}^{1/2}-(m_BE)^{1/2}] / [\{m_W(E+V)\}^{1/2}+(m_BE)^{1/2}]$$
$$= (1-\{m_BE/m_W(E+V)\}^{1/2}] / [1+\{m_BE/m_W(E+V)\}^{1/2}]$$

Further, when $m_B = m_W$, the reflectivity R is calculated by:

$$R = [1-\{E/(E+V)\}^{1/2}]/[1+\{E/(E+V)\}^{1/2}] \tag{6}.$$

When E/(E+V) = x , Eq. 6 is transformed into:

$$R = (1-x^{1/2}) / (1+x^{1/2}) \tag{7}.$$

The characteristic of the reflectivity R with respect to the energy ratio x obtained by Eq. 6 is shown in Figure 2. And when each of the second layer B and the first layer W is laminated S times, the reflectivity $R_S$ of the quantum-wave incident facet is calculated by:

$$R_S = [(1-x^S) / (1+x^S)]^2 \tag{8}.$$

When the condition x ≤ 0.1 is satisfied, R ≥ 0.52. Accordingly, the relation between E and V is satisfied with:

$$E \leq V/9 \tag{9}$$

Since the kinetic energy E of the conducting electrons in the second layer B exists near the bottom of the conduction band, the relation of Eq. 9 is satisfied and the reflectivity R at the interface between the second layer B and the first layer W becomes 52 % or more. Consequently, the multiple quantum well layer structure can reflect quantum wave of electrons effectively.

Further, utilizing the energy ratio x enables the thickness ratio $D_B/D_W$ of the second layer B to the first layer W to be obtained by:

$$D_B/D_W = [m_W / (m_Bx)]^{1/2} \tag{10}.$$

Thicknesses of the first layer W and the second layer B are determined for selectively transmitting one of holes and electrons, because of a difference in potential energy between the valence and the conduction bands, and a difference in effective mass of holes and electrons in the first layer W and the second layer B. Namely, the optimum thickness of the first and the second layers for reflecting electrons is not optimum for reflecting holes. Eqs. 1-1 and 1-2 refer to a structure of the quantum-wave interference layer for reflecting electrons selectively. The thickness for selectively reflecting electrons is designed based on a difference in potential energy of the conduction band and effective mass of electrons. Consequently, the quantum-wave interference layer has a high reflectivity for electrons, but not for holes.

Further, the thickness for selectively reflecting holes is designed based on a difference in potential energy of the valence band and effective mass of holes, realizing another type of quantum-wave interference layer which can reflect holes and transmits electrons.

Accordingly, a light-emitting semiconductor device which comprises a quantum-wave interference layer useful as a reflection layer and an emission layer with a single layer structure, with a single quantum well (SQW) structure as a well layer or with a multiple quantum well (MQW) structure having plural pairs of a well layer and a barrier layer as described above can be obtained. A band gap energy of the emission layer is smaller than those of any component layers in the quantum-wave interference layer. As a result, electrons and holes are easily accumulated in the emission layer or in the well layer formed in the emission layer, resulting in forming electron-hole pairs and improving luminous efficiency.

(Tenth, eleventh and fifteenth aspects of the present invention)

The principle of the second kind of quantum-wave interference layer of the present invention is explained hereinafter. When thicknesses of the first layer W and the second layer B are determined by multiplying an even number by one fourth of a quantum-wave wavelength, for example, a half of a quantum-wave wavelength, a standing wave rises in a quantum-wave interference layer, and a resonant conduction is occurred. That is, when a quantum-wave period of the standing wave and a potential period of the quantum-wave interference layer is corresponded to each other, a scattering of the carrier in each layer is suppressed, and a conduction of a high mobility is realized.

Thicknesses of the first layer W and the second layer B are determined for selectively transmitting one of holes and electrons, because of a difference in potential energy between the valence and the conduction bands, and a difference in effective mass of holes and electrons in the first layer W and the second layer B. Namely, the optimum thickness of the first and the second layers for transmitting electrons is not optimum for transmitting holes. Eqs. 3-1 and 3-2 refer to a structure of the quantum-wave interference layer for transmitting electrons selectively. The thickness for selectively transmitting electrons is designed based on a difference in potential energy of the conduction band and effective mass of electrons. Consequently, the quantum-wave interference layer has a high transmittivity (or a high mobility) for electrons, but not for holes.

Further, the thickness for selectively transmitting holes is designed based on a difference in potential energy of the valence band and effective mass of holes, realizing another type of quantum-wave interference layer as a hole transmission layer, which has a high mobility for holes and which has an ordinary mobility for electrons.

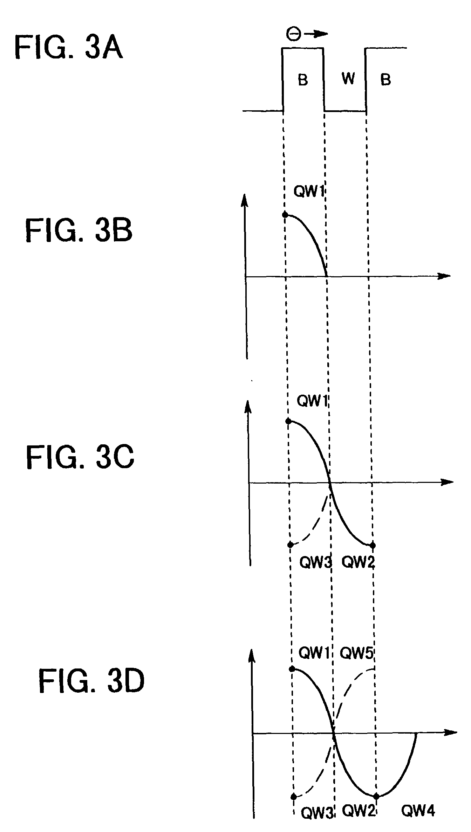

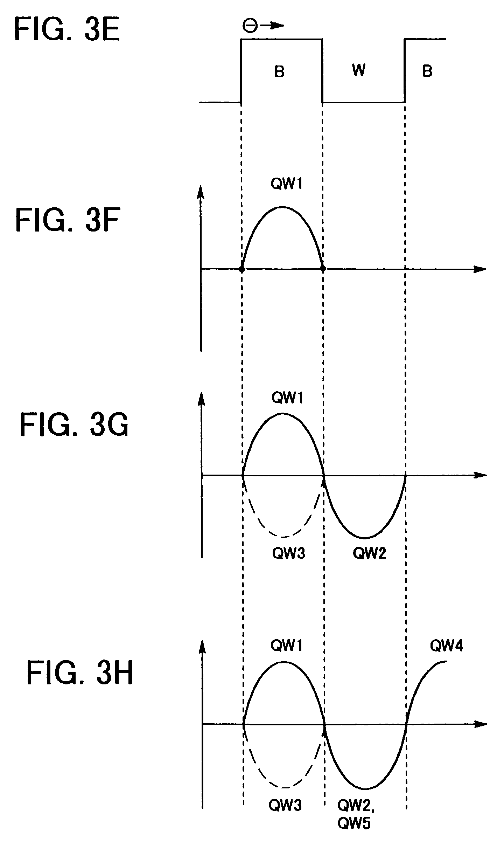

Further explanation can be obtained by FIGS. 3A-3H. FIGS. 3A-3H illustrate the relationship between reflection of quantum-wave of electrons in a potential of quantum-well structure and a period of potential representing a conduction band of a multiple quantum well (MQW). FIGS. 3A-3D show the relationship when the period, i.e., width of the second layer B or the first layer W, of the potential is equal to an odd number multiplied by one fourth of the wavelength of propagated election quantum-wave. This type of the potential is named as $\lambda/4$ type potential hereinafter. FIGS. 3E-3H show when the period of the potential is equal to a natural number multiplied by a half of the wavelength of propagated electron. This type of the potential is named as $\lambda/2$ type potential hereinafter. In order to make it visually intelligible, thickness of each layers is unified in FIGS. 3A-3H. Electrons existing around the bottom of a conduction band of the second layer B conduct from left to right as shown by an arrow in FIGS. 3A and 3E. And in FIGS. 3B and 3F, the electrons reach the interface between the first layer W and the second layer B.

When the quantum-wave of the electrons reaches the interface between the second layer B and the first layer W in the $\lambda/4$ type potential, a transmission wave QW2 and a reflection wave QW3 having a phase equal to that of the transmission wave QW2, are generated with respect to an incident wave QW1 as shown in FIG. 3C. Then when the transmission wave QW2 reaches the interface between the first layer W and the second layer B, a transmission wave QW4 and a reflection wave QW5 having a phase opposite to that of the transmission wave QW4 are generated as shown in FIG. 3D. The relationship between phases of the transmission wave and the reflection wave at the interface depends on falling or rising of a potential of the conduction band at the interface. In order to make it visually intelligible, each amplitudes of QW1, QW2, QW3, QW4, and QW5 is unified in FIGS. 3A-3H.

With respect to the $\lambda/4$ type potential of the multiple quantum well, the propagating quantum-wave of electrons represented by QW1, QW2 and QW4 and the reflecting quantum-wave of electrons represented by QW3 and QW5 cancels with each other, as shown in FIG. 3D. The quantum-wave of electrons represented by the QW1, QW2 and QW4 propagates from left to right, and the quantum-wave of electrons represented by the QW3 and QW5, generated by the reflection at two interfaces, propagates from right to left. Accordingly, a multiple quantum well, having a potential which is formed in a period, i.e., the width of the first layer W and the second layer B, determined by multiplying by an odd number one fourth of quantum-wave wavelength of propagated electrons, cancels the quantum-wave of electrons. In short, the multiple quantum well functions as a reflection layer which does not propagate electrons.

With respect to a multiple quantum well, having a potential which is formed in a period, i.e., the width of the first layer W and the second layer B, determined by multiplying by an even number one fourth of quantum-wave wavelength of propagated electrons, i.e., $\lambda/2$ type potential, as shown in FIGS. 3E-3H, the quantum-wave of electrons can become a standing wave.

Similarly, when a quantum-wave of electrons reaches the interface between the second layer B and the first layer W in the $\lambda/2$ type potential, a transmission wave QW2 and a reflection wave QW3 having a phase corresponding to that of the transmission wave QW2, are generated with respect to an incident wave QW1 as shown in FIG. 3G. Then when the transmission wave QW2 reaches the interface between the first layer W and the second layer B, a transmission wave QW4 and a reflection wave QW5 having a phase opposite to that of the transmission wave QW4 are generated as shown in FIG. 3H. With respect to $\lambda/2$ type potential of the multiple quantum well, the propagating quantum-wave of electrons represented by QW1, QW2 and QW4 and the reflecting quantum-wave of electrons represented by QW5 intensifies to each other, as shown in FIG. 3H. On the other hand, the reflection waves QW3 and QW5 can be considered to cancel with each other and the quantum-wave of electrons which is propagated from left to right in FIG. 3E can be a standing wave. Accordingly, with respect to the multiple quantum well, having a potential which is formed in a period, i.e., the width of the first layer W and the second layer B, determined by multiplying by an odd number one fourth of quantum-wave wavelength of propagated electrons, the quantum-wave of electrons can become a standing wave and a transmission layer having a high transmittivity (or a high mobility) for electrons can be realized.

Alternatively, a multiple quantum well, having a potential which is formed in a period determined by multiplying by a natural number half of quantum-wave wavelength of holes, can be applied to the relationship described above.

Accordingly, when a light-emitting semiconductor device having a quantum-wave interference layer as a transmission layer comprises an emission layer with either one of a single layer structure, a single quantum well (SQW) structure and a multiple quantum well (MQW) structure, whose band gap energy is smaller than those of any component layers in the quantum-wave interference layer, electrons and holes are easily accumulated in the emission layer or in the well layer formed in the emission layer. As a result, electron-hole pairs can be easily generated and luminous efficiency can be improved. When the light emitting semiconductor device has both of the quantum-wave interference layers as the reflection layer and the transmission layer, the effect described above is more improved.

(Fifth and twelfth aspects of the present invention)

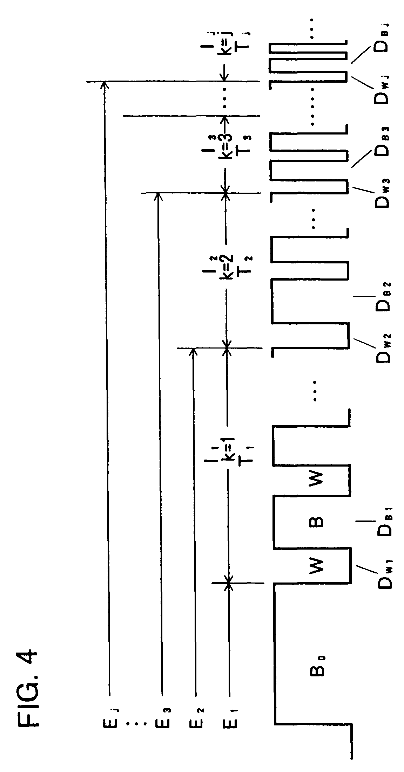

As shown in FIG. 4, a plurality of partial quantum-wave interference layers $I_{Rk}$ as the quantum-wave interference layer may be formed corresponding to each of a plurality of kinetic energy levels $E_{Rk}$. Each of the partial quantum-wave interference layers $I_{Rk}$ has $T_{Rk}$ periods of a first layer W and a second layer B as a unit whose respective thicknesses ($D_{RWk}$, $D_{RBk}$) are determined by Eqs. 2-1 and 2-2. The plurality of the partial quantum-wave interference layer $I_{Rk}$ is arranged in series with respect to the number k of kinetic energy levels $E_{Rk}$. That is, the quantum-wave interference layer is formed by a serial connection of $I_{R1}$, $I_{R2}$, ..., and $I_{Rj}$. As shown in FIG. 4, electrons with each of the kinetic energy levels $E_{Rk}$ are reflected by the corresponding partial quantum-wave interference layers $I_{Rj}$. Accordingly, electrons belonging to each of the kinetic energy levels from $E_{R1}$ to $E_{Rj}$ are reflected effectively. By designing the intervals between the kinetic energies to be short, thicknesses of the first layer W and the second layer B ($D_{RWk}$, $D_{RBk}$) in each of the partial quantum-wave interference layers $I_{Rk}$ vary continuously with respect to the value k. Similarly, a plurality of partial quantum-wave interference layers $I_{Tk}$ may be formed corresponding to each of a plurality of kinetic energy levels $E_{Tk}$. Each of the partial quantum-wave interference layers $I_{Tk}$ has $T_{Tk}$ periods of a first layer W and a second layer B as a unit whose respective thicknesses ($D_{TWk}$, $D_{TBk}$) are determined by Eqs. 4-1 and 4-2. The plurality of the partial quantum-wave interference layer $I_{Tk}$ is arranged in series with respect to the number k of kinetic energy levels $E_{Tk}$. That is, the quantum-wave interference layer is formed by a serial connection of $I_{T1}$, $I_{T2}$, ..., and $I_{Tj}$. This quantum-wave interference layer becomes to have a high transmittivity (or a high mobility) with carriers. In FIG. 4, ($D_{TWk}$, $D_{TBk}$), $I_{Tk}$, and $T_{Tk}$ are not distinguished from ($D_{TWk}$, $D_{TBk}$), $I_{Tk}$, and $T_{Tk}$, respectively, and each of them is represented by $D_{Wk}$, $D_{Bk}$, $I_k$ and $T_k$.

(Sixth and thirteenth aspects of the present invention)

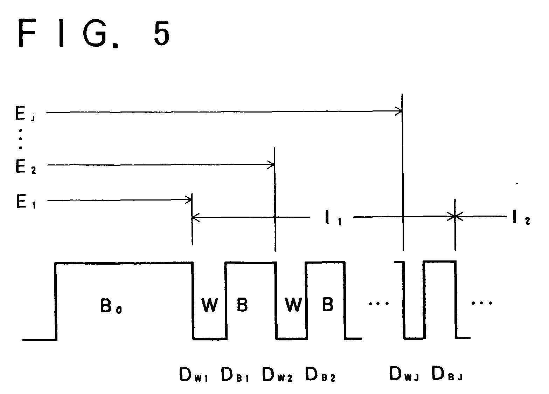

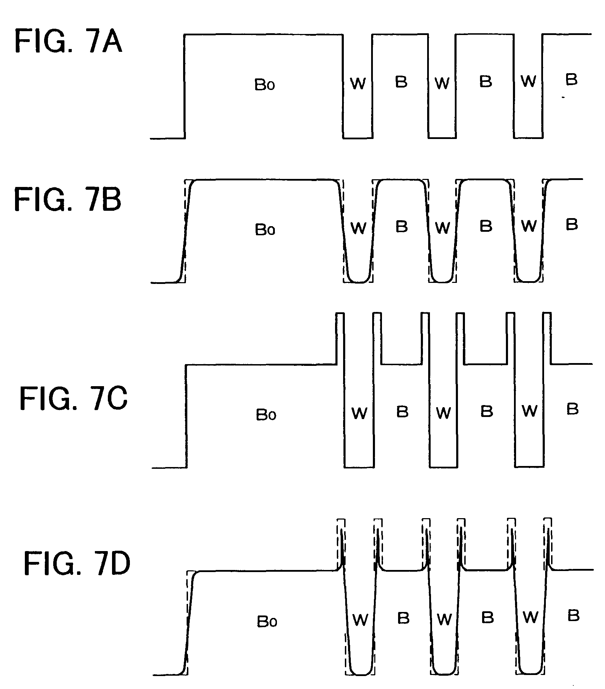

As shown in FIG. 5, a plurality of partial quantum-wave interference layers may be formed with an arbitrary period as the quantum-wave interference layer. Each of the partial quantum-wave interference layers $I_{R1}$, $I_{R2}$, ... is made of serial pairs of the first layer W and the second layer B with widths ($D_{RWk}$, $D_{RBk}$) determined by Eqs. 2-1 and 2-2. That is, the partial quantum-wave interference layer, e.g., $I_{R1}$, is constructed with serial layers of width ($D_{RW1}$, $D_{RB1}$), ..., ($D_{RWk}$, $D_{RBk}$), ..., ($D_{RWj}$, $D_{RBj}$). A plurality $I_{R1}$, $I_{R2}$, ... of layers such as $I_{R1}$ are connected in series to form the total quantum-wave interference layer. Accordingly, electrons of the plurality of kinetic energy levels $E_{Rk}$ are reflected by each pair of layers in each partial quantum-wave interference layers. By designing the intervals between kinetic energies to be short, thicknesses of the pair of the first layer W and the second layer B ($D_{RWk}$, $D_{RBk}$) in a certain partial quantum-wave interference layer $I_{Rk}$ varies continuously with respect to the value k. Similarly, a plurality of partial quantum-wave interference layers, each of which is made of serial pairs of the first layer W and the second layer B with widths ($D_{TWk}$, $D_{TBk}$) determined by Eqs. 4-1 and 4-2, may be formed with an arbitrary period. That is, the partial quantum-wave interference layer is constructed with serial layers of width ($D_{TW1}$, $D_{TB1}$), ..., ($D_{TWk}$, $D_{TBk}$), ..., ($D_{TWj}$, $D_{TBj}$). This quantum-wave interference layer becomes to have a high transmittivity (or a high mobility) with carriers. In FIG. 7, ($D_{RWk}$, $D_{RBk}$), $I_{Rk}$, and $T_{Rk}$ are not distinguished from ($D_{TWk}$, $D_{TBk}$), $I_{Tk}$, and $T_{Tk}$, respectively, and each of them is represented by $D_{Wk}$, $D_{Bk}$, $I_k$ and $T_k$.

(Seventh and fourteenth aspects of the present invention)

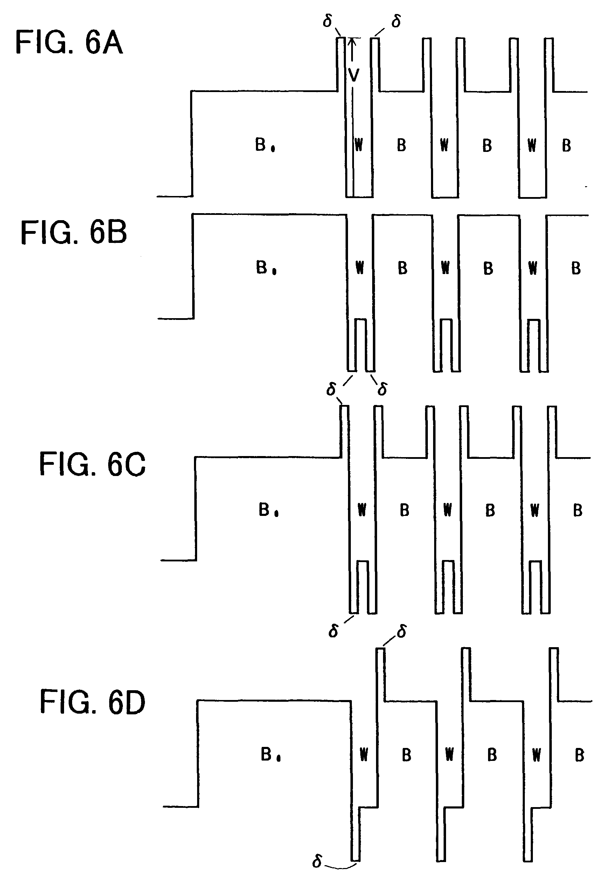

FIGS. 6A-6D illustrate to form a $\delta_R$ layer (disclosed as a $\delta$ layer in FIGS. 4A-4D) at the interface between the first layer W and the second layer B of the quantum-wave interference layer which functions as a reflection layer. The $\delta_R$ layer has a relatively thinner thickness than both of the first layer W and the second layer B and sharply varies an energy band. By sharply varying the band gap of the interfaces, the potential energy V of an energy band becomes larger substantially and the value x of Eq. 7 becomes smaller, as shown in FIGS. 6A-6D. This is shown in FIGS. 7A-7D. Without forming a $\delta_R$ layer as shown in FIG. 7A, a part of component of the first layer W and the second layer B mixes when the second layer B is laminated on the first layer W, and an energy band gap which varies sharply cannot be obtained, as shown in FIG. 7B. When a $\delta_R$ layer is formed at each interfaces of the first and the second layers as shown in FIG. 7C, even if a par of component of the first layer W and the second layer B mixes, an energy band gap varies sharply compared with the case without $\delta_R$ layers, as shown in FIG. 7D.

Variations are shown in FIGS. 6A to 6D. The $\delta_R$ layer may be formed on both ends of the every first layer W as shown in FIGS. 6A to 6D. In FIG. 6A, the $\delta_R$ layers are formed so that an energy level higher than that of the second layer B may be formed. In FIG. 6B, the $\delta_R$ layers are formed so that a band having lower bottom than that of the first layer W may be formed. In FIG. 6C, the $\delta_R$ layers are formed so that the energy level higher than that of the second layer B and the energy level lower than that of the first layer W may be formed. As an alternative to the variation shown in FIG. 6C, the $\delta_R$ layer can be formed on only either one end of every layer as shown in FIG. 6D.

A $\delta_T$ layer can be formed at the interface between the first layer W and the second layer B of the quantum-wave interference layer which functions as a transmission layer. The $\delta_T$ layer which has a relatively thinner thickness than both of the first layer W and the second layer B of the quantum-wave interference layer which functions as a transmission layer and sharply varies an energy band has the same effect as that of the $\delta_R$ layer formed at the interface between the first layer W and the second layer B of the quantum-wave interference layer which functions as a reflection layer. The $\delta_T$ layer may be formed in one of a plural quantum-wave interference layers or may be formed in all of the layers.

(Ninth aspect of the present invention)

By forming a thick second layer $B_{R0}$ at the side of an incident plane of the quantum-wave interference layer, resonance tunneling conduction can be prevented effectively and carriers are reflected effectively. In FIG. 1, the layer $B_{R0}$ is represented by $B_0$.

When an emission layer having a multiple quantum well structure is formed between the first and the second kinds of quantum-wave interference layers which function as a reflection layer and a transmission layer, carriers tend to be accumulated easily in the emission layer and a luminous efficiency increases. When an emission layer is formed between the first and the second kinds of quantum-wave interference layers for electrons and between the first and the second kinds of quantum-wave interference layers for holes, a luminous efficiency increases more. This emission layer may contact to either the first or the second kinds of quantum-wave interference layer for electrons or may contact to either the first or the second kind of quantum-wave interference layer for holes. It may not contact to any of the first or the second kind of quantum-wave interference layer for electrons or holes. Other functional layers may be formed adjacent to the emission layer if necessary.

BRIEF DESCRIPTION OF THE DRAWINGS

Other objects, features, and characteristics of the present invention will become apparent upon consideration of the following description and the appended claims with reference to the accompanying drawings, all of which form a part of the specification, and wherein reference numerals designate corresponding parts in the various figures, wherein:

FIG. 1 is an explanatory view of a conduction band of a quantum interference layer of the present invention;
FIG. 2 is a graph showing a relation between an energy ratio x and a reflectivity R;
FIGS. 3A-3D are explanatory views of a quantum-wave interference layer as a reflection layer of carriers;
FIGS. 3E-3H are explanatory views of a quantum-wave interference layer as a transmission layer of carriers;
FIG. 4 is an explanatory view of partial quantum-wave interference layers $I_k$ according to the present invention;
FIG. 5 is an explanatory view of partial quantum-wave interference layers $I_k$ according to the present invention;
FIGS. 6A-6D are explanatory views of configuration of $\delta$ layers according to the present invention;
FIGS. 7A-7D are views showing energy level for explaining a function of $\delta$ layers according to the present invention;
FIG. 8 is a sectional view showing a structure of a light-emitting diode 100 according to the first embodiment of the present invention;

FIG. 9 is a graph showing luminous characteristics of the light-emitting diode 100 according to the first embodiment of the present invention; and

FIG. 10 is a sectional view showing a structure of a light-emitting device 200 according to the second embodiment of the present invention.

DETAILED DESCRIPTION OF THE PREFERRED EMBODIMENTS

The invention will be more fully understood by reference to the following examples.

Example 1

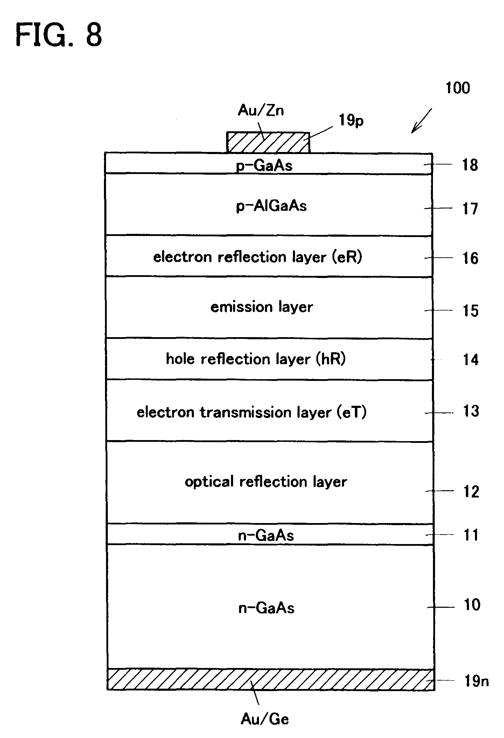

FIG. 8 is a sectional view of a light-emitting diode 100 comprising one quantum-wave interference layer on a p-type layer side and two quantum-wave interference layers on an n-type layer side. The light-emitting device 100 has a substrate 10 made of gallium arsenide (GaAs). A GaAs buffer layer 11 of n-type conduction, having a thickness generally of 0.3 $\mu$m and an electron concentration of $2 \times 10^{18}/cm^3$, is formed on the substrate 10. An optical reflection layer 12, which has a thickness of about 3$\mu$m and has a multiple layer structure comprising 25 pairs of an n-GaAs layer and an n-Al$_{0.5}$Ga$_{0.5}$As layer, is formed on the buffer layer 11. The n-GaAs layer has a thickness of 55nm and an electron concentration of $2 \times 10^{18}/cm^3$, and the n-Al$_{0.5}$Ga$_{0.5}$As layer has a thickness of 63nm and an electron concentration of $2 \times 10^{18}/cm^3$.

An electron transmission layer (eT) 13, which has a thickness of about 0.6$\mu$m and has a multiple layer structure comprising 20 pairs of an n-GaAs layer and an n-Al$_{0.5}$Ga$_{0.5}$As layer, is formed on the optical reflection layer 12. The n-GaAs layer has a thickness of 10nm and an electron concentration of $2 \times 10^{18}/cm^3$, and the n-Al$_{0.5}$Ga$_{0.5}$As layer has a thickness of 22nm and an electron concentration of $1 \times 10^{18}/cm^3$.

A hole reflection layer (hR) 14, which has a thickness of about 20nm and has a multiple layer structure comprising 10 pairs of an n-GaAs and an n-Al$_{0.5}$Ga$_{0.5}$As layer, is formed on the electron transmission layer (eT) 13. The n-GaAs layer has a thickness of 1nm and an electron concentration of $1 \times 10^{18}/cm^3$, and the n-Al$_{0.5}$Ga$_{0.5}$As layer has a thickness of 1.2nm and an electron concentration of $1 \times 10^{18}/cm^3$.

An emission 15 having a multiple layer structure is formed on the hole reflection layer (hR) 14. The following layers are laminated in the emission layer 15 on the hole reflection layer (hR) 14 in sequence: a non-doped i-Al$_{0.5}$Ga$_{0.5}$As layer having a thickness of 50nm; a non-doped i-Ga$_{0.89}$In$_{0.11}$As layer having a thickness of 14.5nm; a non-doped i-Al$_{0.5}$Ga$_{0.5}$As layer having a thickness of 3nm; a non-doped i-Ga$_{0.89}$In$_{0.11}$As layer having a thickness of 14.5nm; a non-doped i-Al$_{0.5}$Ga$_{0.5}$As layer having a thickness of 3nm; a non-doped i-Ga$_{0.89}$In$_{0.11}$As layer having a thickness of 14.5mn; and a non-doped i-Al$_{0.5}$Ga$_{0.5}$As layer having a thickness of 50nm. The i-Ga$_{0.89}$In$_{0.11}$As layer is a well layer and the i-Al$_{0.5}$Ga$_{0.5}$As layer is a barrier layer. Accordingly, the emission layer 15 has a multiple quantum well (MQW) structure, and has a thickness of about 0.15$\mu$m.

An electron reflection layer (eR) 16, which, has a thickness of about 0.3$\mu$m and has a multiple layer structure comprising 20 pairs of a p-GaAs and a p-Al$_{0.5}$Ga$_{0.5}$As layer, is formed on the emission layer 15. The p-GaAs layer has a thickness of 5nm and a hole concentration of $1 \times 10^{18}/cm^3$, and the p-Al$_{0.5}$Ga$_{0.5}$As layer has a thickness of 11nm and a hole concentration of $1 \times 10^{18}/cm^3$.

A p-cladding layer 17 of p-Al$_{0.5}$Ga$_{0.5}$As, having a hole concentration of $1 \times 10^{18}/cm^3$ and a thickness of about 0.5$\mu$m, is formed on the electron reflection (eR) layer 16. A p-contact layer 18 of p-GaAs, having a hole concentration of $2 \times 10^{18}/cm^3$ and a thickness of about 30nm, is formed on the p-cladding layer 17. An electrode layer 19n made of gold and germanium (Au/Ge), having a thickness generally of 0.2 $\mu$m, is formed so as to cover the entire back of the substrate 10. Another electrode layer 19p made of Au/Zn, having a thickness generally of 0.2 $\mu$m, is formed on some portion of the p-contact layer 18. And the substrate 10 has a diameter of 2.0 inches and the normal direction of its main surface is offset toward the [011] axis by 15 degree from the (100) plane.

The light-emitting diode 100 was manufactured by gas source molecular beam epitaxial deposition (GS-MBE) which is an epitaxial growth method under extremely high vacuum condition. GS-MBE is different from a conventional MBE which supplies group III and V elements both from solid state sources. In GS-MBE, group III elements such as indium (In), gallium (Ga), and aluminum (Al) are supplied from a solid source and group V elements such as arsenic (As) and phosphorous (P) are supplied by heat decomposition of gas material such as AsH$_3$ and PH$_3$. Alternatively, the light-emitting diode 100 can be manufactured by metal organic chemical vapor deposition (MOCVD).

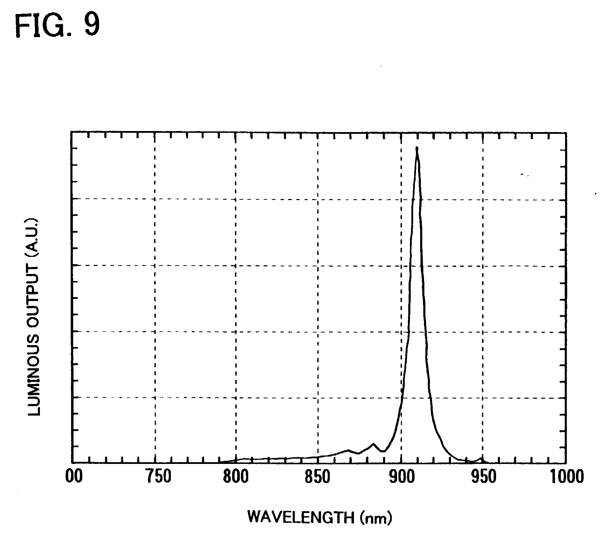

FIG. 9 is a graph showing luminous characteristics of the light-emitting diode 100. A luminous wavelength was 908nm and half-width was 12nm. Compared with a light-emitting diode having the same structure as that of the light-emitting diode 100 except that an emission layer is formed as a single i-GaAs, luminous intensity of the light-emitting diode 100 is 1.5 times larger than that of the light-emitting diode having the i-GaAs emission layer. This is because a band gap energy of i-Ga$_{0.89}$In$_{0.11}$As which forms a well layer in the emission layer 15 is smaller than those of Al$_{0.5}$Ga$_{0.5}$As and GaAs which forms other layers. As a result, electron-hole pairs are easily generated in i-

$Ga_{0.89}In_{0.11}As$ which forms a well layer in the emission layer 15. Actually, the band gap energy of i-$Ga_{0.89}In_{0.11}As$ which forms a well layer in the emission layer 15 is about 1.31ev, and band gap energy of $Al_{0.5}Ga_{0.5}As$ and GaAs layers are about 1.74ev and 1.43ev, respectively.

Example 2

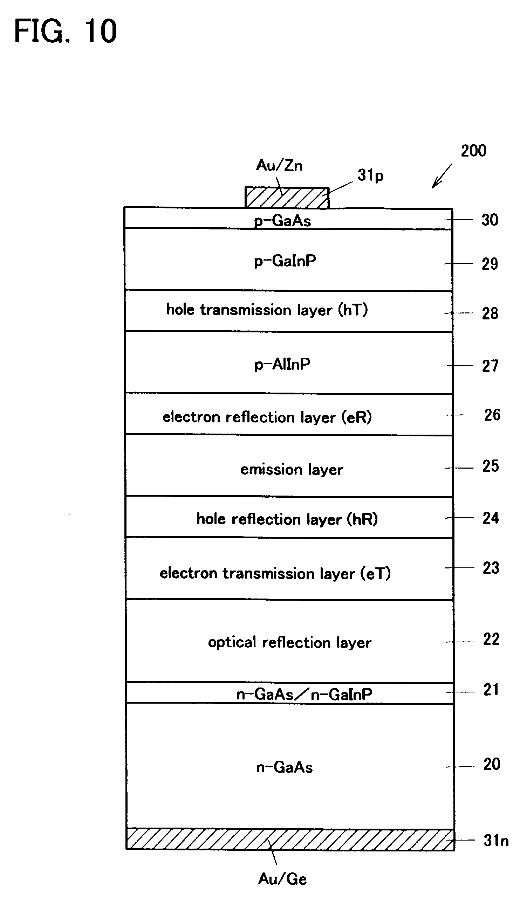

FIG. 10 is a sectional view of a light-emitting diode 200 comprising two quantum-wave interference layers on a p-type layer side and two quantum-wave interference layers on an n-type layer side. The light-emitting device 200 has a substrate 20 made of gallium arsenide (GaAs). A buffer layer 21 comprising an n-GaAs layer, having a thickness of 0.3μm and an electron concentration of $2 \times 10^{18}$/cm$^3$, and an n-$Ga_{0.5}In_{0.5}P$ layer, having a thickness of 0.2μm and an electron concentration of $2 \times 10^{18}$/cm$^3$, is formed on the substrate 20. An optical reflection layer 22, which has a thickness of about 2.5μm and has a multiple layer structure comprising 25 pairs of an n-$Al_{0.5}In_{0.5}P$ layer and an n-$Ga_{0.5}In_{0.5}P$ layer, is formed on the buffer layer 21. The n-$Al_{0.5}In_{0.5}P$ layer has a thickness of 53nm and an electron concentration of $2 \times 10^{18}$/cm$^3$, and the n-$Ga_{0.5}In_{0.5}P$ layer has a thickness of 48nm and an electron concentration of $2 \times 10^{18}$/cm$^3$.

An electron transmission layer (eT) 23, which has a thickness of about 0.5μm and has a multiple layer structure comprising 20 pairs of an n-$Al_{0.5}In_{0.5}P$ layer and an n-$Ga_{0.5}In_{0.5}P$ layer, is formed on the optical reflection layer 22. The n-$Ga_{0.5}In_{0.5}P$ layer has a thickness of 10nm and an electron concentration of $2 \times 10^{18}$/cm$^3$, and the n-$Al_{0.5}In_{0.5}P$ layer has a thickness of 14nm and an electron concentration of $2 \times 10^{18}$/cm$^3$. And 40 n-$Al_{0.33}Ga_{0.33}In_{0.33}P$ layers are formed between each interfaces of the n-$Al_{0.5}In_{0.5}P$ layer and the n-$Ga_{0.5}In_{0.5}P$ layer. The n-$Al_{0.33}Ga_{0.33}In_{0.33}P$ layer has a thickness of 1.3nm.

A hole reflection layer (hR) 24, which has a thickness of about 20nm and has a multiple layer structure comprising 10 pairs of an n-$Al_{0.5}In_{0.5}P$ layer and an n-$Ga_{0.5}In_{0.5}P$ layer, is formed on the electron transmission layer (eT) 23. The n-$Ga_{0.5}In_{0.5}P$ layer has a thickness of 1nm and an electron concentration of $1 \times 10^{18}$/cm$^3$, and the n-$Al_{0.5}In_{0.5}P$ layer has a thickness of 1.2nm and an electron concentration of $1 \times 10^{18}$/cm$^3$.

An emission 25 having a multiple layer structure is formed on the hole reflection layer (hR) 24. The following layers are laminated in the emission layer 25 on the hole reflection layer (hR) 24 in sequence: a non-doped i-$Al_{0.5}In_{0.5}P$ layer having a thickness of 50nm; a non-doped i-$Ga_{0.3}In_{0.7}P$ layer having a thickness of 12nm; a non-doped i-$Al_{0.5}In_{0.5}P$ layer having a thickness of 3nm; a non-doped i-$Ga_{0.3}In_{0.7}P$ layer having a thickness of 12nm; a non-doped i-$Al_{0.5}In_{0.5}P$ layer having a thickness of 3nm; a non-doped i-$Ga_{0.3}In_{0.7}P$ layer having a thickness of 12nm; and a non-doped i-$Al_{0.5}In_{0.5}P$ layer having a thickness of 50nm. The i-$Ga_{0.3}In_{0.7}P$ layer is a well layer and the i-$Al_{0.5}In_{0.5}P$ layer is a barrier layer. Accordingly, the emission layer 25 has a multiple quantum well (MQW) structure, and has a thickness of about 0.15μm.

An electron reflection layer (eR) 26, which has a thickness of about 0.3μm and has a multiple layer structure comprising 20 pairs of a p-$Al_{0.5}In_{0.5}P$ layer and a p-$Ga_{0.5}In_{0.5}P$ layer, is formed on the emission layer 25. The p-$Ga_{0.5}In_{0.5}P$ layer has a thickness of 5nm and a hole concentration of $1 \times 10^{18}$/cm$^3$, and the p-$Al_{0.5}In_{0.5}P$ layer has a thickness of 7nm and a hole concentration of $1 \times 10^{18}$/cm$^3$. And 40 $Al_{0.33}Ga_{0.33}In_{0.33}P$ layers are formed between each interfaces of the p-$Al_{0.5}In_{0.5}P$ layer and the p-$Ga_{0.5}In_{0.5}P$ layer. The n-$Al_{0.33}Ga_{0.33}In_{0.33}P$ layer has a thickness of 1.3nm.

A p-cladding layer 27 of p-$Al_{0.5}In_{0.5}P$, having a hole concentration of $1 \times 10^{18}$/cm$^3$ and a thickness of about 0.4μm, is formed on the electron reflection (eR) layer 26. A hole transmission layer (hT) 28, which has a thickness of about 40nm and has a multiple layer structure comprising 10 pairs of a p-$Al_{0.5}In_{0.5}P$ layer and a p-$Ga_{0.5}In_{0.5}P$ layer, is formed on the p-cladding layer 27. The p-$Ga_{0.5}In_{0.5}P$ layer has a thickness of 2nm and a hole concentration of $2 \times 10^{18}$/cm$^3$, and the p-$Al_{0.5}In_{0.5}P$ layer has a thickness of 2.4nm and a hole concentration of $2 \times 10^{18}$/cm$^3$.

A p-$Ga_{0.5}In_{0.5}P$ layer, having a hole concentration of $2 \times 10^{18}$/cm$^3$ and a thickness of about 25nm, is formed as a second p-contact layer 29 on the hole transmission layer (hT) 28. A p-GaAs layer, having a hole concentration of $2 \times 10^{18}$/cm$^3$ and a thickness of about 60nm, is formed as a first p-contact layer 30 on the second p-contact layer 29. An electrode layer 31n made of gold and germanium (Au/Ge), having a thickness generally of 0.2 μm, is formed so as to cover the entire back of the substrate 20. Another electrode layer 31p made of Au/Zn, having a thickness generally of 0.2 μm, is formed on some portion of the first p-contact layer 30. And the substrate 20 has a diameter of 2.0 inches and the normal direction of its main surface is offset toward the [011] axis by 15 degree from the (100) plane.

The light-emitting diode 200 was manufactured by gas source molecular beam epitaxial deposition (GS-MBE), the same method that the light-emitting diode 100 was manufactured by. Alternatively, the light-emitting diode 200 can be manufactured by metal organic chemical vapor deposition (MOCVD).

With respect to luminous characteristics of the light-emitting diode 200, a luminous wavelength was 682nm and half-width was 18nm. Compared with a light-emitting diode having the same structure as that of the light-emitting diode 200 except that an emission layer is formed as a single i-$Ga_{0.5}In_{0.5}P$ layer having a thickness of 14nm, the luminous intensity of the light-emitting diode 200 is 1.5 times larger than that of the light-emitting diode having the i-

$Ga_{0.5}In_{0.5}P$ emission layer. This is because a band gap energy of i-$Ga_{0.3}In_{0.7}P$ which forms a well layer in the emission layer 25 is smaller than those of $Al_{0.5}In_{0.5}P$ and $Ga_{0.5}In_{0.5}P$ which forms other layers. As a result, electron-hole pairs are easily formed in i-$Ga_{0.3}In_{0.7}P$ which forms a well layer in the emission layer 25. Actually, the band gap energy of i-$Ga_{0.3}In_{0.7}P$ which forms a well layer in the emission layer 25 is about 1.56eV, and band gap energy of $Al_{0.5}In_{0.5}P$ and $Ga_{0.5}In_{0.5}P$ layers are about 2.13ev and 1.76ev, respectively.

As characteristics of the light-emitting diodes 100 and 200 in the first and the second embodiments of the present invention, temperature variation of their luminous characteristics was measured and a temperature dependency of luminous wavelength and half-width in a range from 20°C to 80°C was obtained. In the light-emitting diode 100 of the first embodiment, a temperature dependency of luminous wavelength is from 0.06nm/°C to 0.09nm/°C and a temperature dependency of half-width is less than 0.03nm/°C. In the light-emitting diode 200 of the second embodiment, a temperature dependency of luminous wavelength is less than 0.02nm/°C and a temperature dependency of half-width is from 0.02nm/°C to 0.03nm/°C. The temperature dependencies of luminous wavelength and half-width in the light-emitting diode 100 and 200 are considerably smaller than those in a general commercial product, whose temperature dependencies of luminous wavelength and half-width are 0.2nm/°C and 0.15nm/°C, respectively. Accordingly, the present invention enables temperature dependency to be much smaller compared with a light-emitting diode with conventional layers.

In the first embodiment, two quantum-wave interference layers are formed for electrons in the light-emitting diode 100. The quantum-wave interference layers function as the electron transmission layer 13 and the electron reflection layer 16, and the emission layer 15 and the hole-wave reflection layer 14 are formed between the two quantum-wave interference layers. Alternatively, the hole-wave reflection layer 14 is not necessarily needed. For example, a diode can be formed to have the emission layer 15, the electron transmission layer 13 formed on the n-type? (or the negative electrode) side of the emission layer 15, and the electron reflection layer 16 formed on the p-type (or the positive electrode) side of the emission layer 15 and a quantum-wave interference layer for holes is not existed. In short, a light-emitting diode shown in FIG. 8 may function without the hole reflection layer 14. Because electrons have larger mobility in a semiconductor compared with holes, forming a pair of quantum-wave interference layers as an electron transmission layer and an electron reflection layer, respectively, improves effectivity of a light-emitting diode as in the present invention.

Alternatively, forming quantum-wave interference layers for holes as a transmission layer and as a reflection layer and without forming a quantum-wave interference layer for electrons can be applied to the light-emitting diode of the present invention. Such a diode comprises an emission layer, a hole reflection layer formed on the negative electrode side of the emission layer and a hole transmission layer formed on the positive side of the emission layer. Further alternatively, the light-emitting diode can comprise both pairs of quantum-wave interference layers, or a pair of a hole transmission layer and a hole reflection layer and either one of an electron transmission layer and an electron reflection layer. Order of disposition between the electron transmission layer and the hole reflection layer or between the electron reflection layer and the hole transmission layer is arbitrary.

In the second embodiment, a diode with δ layers are shown. Band gap energy at a potential interface varies sharply and interference effect of quantum-wave is more improved by δ layers. Alternatively, a multiple quantum well (MQW) structure without a δ layer can be applied to a device although its effect will be lowered.

Further, in the second embodiment, a layer having a multiple period structure and the δ layer was made of ternary compounds including $Ga_{0.5}In_{0.5}P/Al_{0.5}In_{0.5}P$ and quaternary compounds including $Al_{0.33}Ga_{0.33}In_{0.33}P$, respectively. Alternatively, the layer having a multiple period structure and a δ layer can be made of binary, ternary and quaternary compounds such as $Al_xGa_yIn_{1-x-y}P$ or $Al_xGa_yIn_{1-x-y}As$, selecting arbitrary composition ratio within the range of $0 \leqq x \leqq 1$, $0 \leqq y \leqq 1$, and $0 \leqq x+y \leqq 1$.

In the present invention, a light-emitting diode was used to show the effectivity of this invention. Alternatively, reducing a band gap energy of a single quantum or a multiple quantum well layer in the emission layer which forms electron-hole pairs is not necessarily limited to a light-emitting device, and can be applied to an arbitrary semiconductor device such as a photodiode, a light-receiving device (e.g., a solar battery), and so on.

As another alternative, the layer having a multiple period structure can be made of multi-junction of hetero-material such as group III-V compound semiconductor, group II-VI compound semiconductors, Si and Ge, and hetero-semiconductor. The desirable compositions are as follows. Each combinations is represented by a composition of a layer having a wide band width / a layer having a narrow band width // a substrate. And x and y are arbitrary values wherein $0 \leqq x \leqq 1$ and $0 \leqq y \leqq 1$, as long as they are not specified. The combinations of desirable compositions shown below are one of optimum examples for a device, and the present invention can be applied to a semiconductor device comprising semiconductor layers of an arbitrary composition.

(1) $Al_xIn_{1-x}P$ / $Ga_yIn_{1-y}P$ // GaAs
(2) $Al_xGa_{1-x}As$ / GaAs // GaAs
(3) $Ga_xIn_{1-x}P$ / InP // InP

(4) $Ga_xIn_{1-x}P$ / $Ga_xIn_{1-x}As$ // GaAs

(5) AlAs / $Al_xGa_{1-x}As$ // GaAs ($0.8 \leqq x \leqq 0.9$)

(6) InP / $Ga_xIn_{1-x}As_yP_{1-y}$ // GaAs

(7) Si / $SiGe_x$ // arbitrary material ($0.1 \leqq x \leqq 0.3$)

(8) Si / $SiGe_xC_y$ // arbitrary material ($0.1 \leqq x \leqq 0.3$, $0 < y \leqq 0.1$)

(9) $Al_{x1}Ga_{y1}In_{1-x1-y1}N$ / $Al_{x2}Ga_{y2}In_{1-x2-y2}N$ // Si, SiC, GaN, or sapphire ($0 \leqq x_1, x_2, y_1, y_2, x_1+y_1, x_2+y_2 \leqq 1$)

In a semiconductor of hetero-material having the above 9 combinations of compositions, doping arbitrary impurities, or adding dopants into the hetero-material to control the conduction type and resistivity, can be applied to the present invention. Alternatively, a part of the composition elements can be replaced with other elements in the same group. For example, a part of group III composition elements such as Al, Ga and In can be replaced with other group III elements, e.g., B and Tl. Also a part of group V composition elements such as P and As can be replaced with other group V elements, e.g., N, Sb, and Bi.

While the invention has been described in connection with what are presently considered to be the most practical and preferred embodiments, it is to be understood that the invention is not to be limited to the disclosed embodiments, but on the contrary, the description is intended to cover various modifications and equivalent arrangements included within the spirit and scope of the appended claims. The present document claims the benefit of Japanese priority document, filed in Japan on August 27, 1999, the entire contents of which is incorporated herein by reference.

Obviously, numerous modifications and variations of the present invention are possible in light of the above teachings. It is therefore to be understood that within the scope of the appended claims, the invention may be practiced otherwise than as specifically described herein.

A light-emitting diode 100 comprises an emission layer with a multiple quantum well (MQW) structure and a quantum-wave interference layer having plural periods of a pair of a first layer and a second layers, and the second layer having a wider band gap than said first layer. A band gap energy of a well layer in the emission layer is smaller than that of any other component layers in the quantum-wave interference layer. As a result, a luminous intensity of the light-emitting diode 100 improved 50% compared with a conventional light-emitting diode.

## Claims

1. A light-emitting semiconductor device comprising:

   an emission layer with a single layer structure; and
   at least one quantum-wave interference layer having plural periods of a pair of a first layer and a second layers, said second layer having a wider band gap than said first layer;
   wherein a band gap between a conduction band and a valence band of said emission layer is smaller than a band gap between a conduction band and a valence band of any component layers which construct said quantum-wave interference layer.

2. A light-emitting semiconductor device comprising:

   an emission layer with a single quantum well structure as a well layer or with a multiple quantum well structure of said well layer and a barrier layer; and
   at least one quantum-wave interference layer having plural periods of a pair of a first layer and a second layers, said second layer having a wider band gap than said first layer;
   wherein a band gap between a conduction band and a valence band of said well layer formed in said emission layer is smaller than a band gap between a conduction band and a valence band of any component layers which construct said quantum-wave interference layer.

3. A light-emitting semiconductor device according to claim 1, wherein at least one of said quantum-wave interference layers has a pair of said first and said second layers, each thickness of which is determined by multiplying by an odd number one fourth of quantum-wave wavelength of carriers in each of said first and said second layers.

4. A light-emitting semiconductor device according to claim 2, wherein at least one of said quantum-wave interference layers has a pair of said first and said second layers, each thickness of which is determined by multiplying by an odd number one fourth of quantum-wave wavelength of carriers in each of said first and said second layers.

5. A light-emitting semiconductor device according to claim 3, wherein said wavelength $\lambda_{RW}$ in said first layer is deter-

mined by a formula $\lambda_{RW} = h/[2m_{RW}(E_R+V_R)]^{1/2}$, said wavelength $\lambda_{RB}$ in said second layer is determined by a formula $\lambda_{RB} = h/(2m_{RB}E_R)^{1/2}$, said thickness of said first layer $D_{RW}$ is determined by a formula $D_{RW} = n_{RW}\lambda_{RW}/4$, and said thickness of said second layer $D_{RB}$ is determined by a formula $D_{RB} = n_{RB}\lambda_{RB}/4$, where h, $m_{RW}$, $m_{RB}$, $E_R$, $V_R$, and $n_{RW}$ and $n_{RB}$ represent a Plank's constant, effective mass of said carrier in said first layer, effective mass of said carrier in said second layer, kinetic energy of carriers at the level near the lowest energy level in said second layer, potential energy of said second layer to said first layer, and odd numbers, respectively.

6. A light-emitting semiconductor device according to claim 4, wherein said wavelength $\lambda_{RW}$ in said first layer is determined by a formula $\lambda_{RW} = h/[2m_{RW}(E_R+V_R)]^{1/2}$, said wavelength $\lambda_{RB}$ in said second layer is determined by a formula $\lambda_{RB} = h/(2m_{RB}E_R)^{1/2}$, said thickness of said first layer $D_{RW}$ is determined by a formula $D_{RW} = n_{RW}\lambda_{RW}/4$, and said thickness of said second layer $D_{RB}$ is determined by a formula $D_{RB} = n_{RB}\lambda_{RB}/4$, where h, $m_{RW}$, $m_{RB}$, $E_R$, $V_R$, and $n_{RW}$ and $n_{RB}$ represent a Plank's constant, effective mass of said carrier in said first layer, effective mass of said carrier in said second layer, kinetic energy of carriers at the level near the lowest energy level in said second layer, potential energy of said second layer to said first layer, and odd numbers, respectively.

7. A light-emitting semiconductor device according to claim 1, wherein said quantum-wave interference layer comprises:

a plurality of partial quantum-wave interference layers $I_{Rk}$ with $T_{Rk}$ periods of a pair of said first layer and said second layer being displaced in series by varying k as 1, 2, ..., and
wherein index k of said plurality of said partial quantum-wave interference layers corresponds to index k of kinetic energy level $E_{Rk}+V_R$ and $E_{Rk}$ and said first and second layers have thicknesses of $n_{RWk}\lambda_{RWk}/4$, and $n_{RBk}\lambda_{RBk}/4$, respectively, where $E_{Rk}+V_R$ and $E_{Rk}$, $\lambda_{RWk}$ and $\lambda_{RBk}$, and $n_{RWk}$, $n_{RBk}$ represent kinetic energy level of carriers flowing into respective said first layer and said second layer, wavelength of quantum-wave of carriers flowing into respective said first layer and said second layer, and odd numbers, respectively, and $\lambda_{RWk}$ and $\lambda_{RBk}$ are determined by functions of $E_{Rk}+V_R$ and $E_{Rk}$, respectively.

8. A light-emitting semiconductor device according to claim 2, wherein said quantum-wave interference layer comprises:

a plurality of partial quantum-wave interference layers $I_{Rk}$ with $T_{Rk}$ periods of a pair of said first layer and said second layer being displaced in series by varying k as 1, 2, ..., and
wherein index k of said plurality of said partial quantum-wave interference layers corresponds to index k of kinetic energy level $E_{Rk}+V_R$ and $E_{Rk}$ and said first and second layers have thicknesses of $n_{RWk}\lambda_{RWk}/4$, and $n_{RBk}\lambda_{RBk}/4$, respectively, where $E_{Rk}+V_R$ and $E_{Rk}$, $\lambda_{RWk}$ and $\lambda_{RBk}$, and $n_{RWk}$, $n_{RBk}$ represent kinetic energy level of carriers flowing into respective said first layer and said second layer, wavelength of quantum-wave of carriers flowing into respective said first layer and said second layer, and odd numbers, respectively, and $\lambda_{RWk}$ and $\lambda_{RBk}$ are determined by functions of $E_{Rk}+V_R$ and $E_{Rk}$, respectively.

9. A light-emitting semiconductor device according to claim 1, wherein said quantum-wave interference layer comprises:

a plurality of partial quantum-wave interference layers, each of said partial quantum-wave interference layers having serial pairs of said first layer and said second layer with serial pairs of thicknesses of ($n_{RW1}\lambda_{RW1}/4$, $n_{RB1}\lambda_{RB1}/4$), ..., ($n_{RWk}\lambda_{RWk}/4$, $n_{RBk}\lambda_{RBk}/4$), ..., ($n_{RWj}\lambda_{RWj}/4$, $n_{RBj}\lambda_{RBj}/4$), and
wherein index k in said partial quantum-wave interference layer corresponds to index k of kinetic energy level $E_{Rk}+V_R$ and $E_{Rk}$, and $E_{Rk}+V_R$ and $E_{Rk}$, $\lambda_{RWk}$ and $\lambda_{RBk}$, and $n_{RWk}$, $n_{RBk}$ represent energy level of carriers flowing into respective said first layer and said second layer, wavelength of quantum-wave of carriers flowing into respective said first layer and said second layer, and odd numbers, respectively, and $\lambda_{RWk}$ and $\lambda_{RBk}$ are determined by functions of $E_{Rk}+V_R$ and $E_{Rk}$, respectively.

10. A light-emitting semiconductor device according to claim 2, wherein said quantum-wave interference layer comprises:

a plurality of partial quantum-wave interference layers, each of said partial quantum-wave interference layers having serial pairs of said first layer and said second layer with serial pairs of thicknesses of ($n_{RW1}\lambda_{RW1}/4$, $n_{RB1}\lambda_{RB1}/4$), ..., ($n_{RWk}\lambda_{RWk}/4$, $n_{RBk}\lambda_{RBk}/4$), ..., ($n_{RWj}\lambda_{RWj}/4$, $n_{RBj}\lambda_{RBj}/4$), and
wherein index k in said partial quantum-wave interference layer corresponds to index k of kinetic energy level

$E_{Rk}+V_R$ and $E_{Rk}$, and $E_{Rk}+V_R$ and $E_{Rk}$, $\lambda_{RWk}$ and $\lambda_{RBk}$, and $n_{RWk}$, $n_{RBk}$ represent energy level of carriers flowing into respective said first layer and said second layer, wavelength of quantum-wave of carriers flowing into respective said first layer and said second layer, and odd numbers, respectively, and $\lambda_{RWk}$ and $\lambda_{RBk}$ are determined by functions of $E_{Rk}+V_R$ and $E_{Rk}$, respectively.

11. A light-emitting semiconductor device according to claim 3 comprising:

a $\delta_R$ layer for sharply varying energy band, being formed between said first and said second layers, wherein said $\delta_R$ layer is substantially thinner than that of said first and said second layers.

12. A light-emitting semiconductor device according to claim 4 comprising:

a $\delta_R$ layer for sharply varying energy band, being formed between said first and said second layers, wherein said $\delta_R$ layer is substantially thinner than that of said first and said second layers.

13. A light-emitting semiconductor device according to claim 3, wherein said quantum-wave interference layer functions as a reflection layer for reflecting said carriers.

14. A light-emitting semiconductor device according to claim 4, wherein said quantum-wave interference layer functions as a reflection layer for reflecting said carriers.

15. A light-emitting semiconductor device according to claim 3, wherein an incident plane of quantum-wave in said quantum-wave interference layer is said second layer having enough thickness to prevent conduction of carriers by a tunneling effect.

16. A light-emitting semiconductor device according to claim 4, wherein an incident plane of quantum-wave in said quantum-wave interference layer is said second layer having enough thickness to prevent conduction of carriers by a tunneling effect.

17. A light-emitting semiconductor device according to claim 1, wherein at least one of said quantum-wave interference layers has a pair of said first and said second layers, each thickness of which is determined by multiplying by an even number one fourth of quantum-wave wavelength of carriers in each of said first and said second layers.

18. A light-emitting semiconductor device according to claim 2, wherein at least one of said quantum-wave interference layers has a pair of said first and said second layers, each thickness of which is determined by multiplying by an even number one fourth of quantum-wave wavelength of carriers in each of said first and said second layers.

19. A light-emitting semiconductor device according to claim 17, wherein said wavelength $\lambda_{TW}$ in said first layer is determined by a formula $\lambda_{TW} = h/[2m_{TW}(E_T+V_T)]^{1/2}$, said wavelength $\lambda_{TB}$ in said second layer is determined by a formula $\lambda_{TB} = h/(2m_{TB}E_T)^{1/2}$, said thickness of said first layer $D_{TW}$ is determined by a formula $D_{TW} = n_{TW}\lambda_{TW}/4$, and said thickness of said second layer $D_{TB}$ is determined by a formula $D_{TB} = n_{TB}\lambda_{TB}/4$, where h, $m_{TW}$, $m_{TB}$, $E_T$, $V_T$, and $n_{TW}$ and $n_{TB}$ represent a Plank's constant, effective mass of said carrier in said first layer, effective mass of said carrier in said second layer, kinetic energy of carriers at the level near the lowest energy level in said second layer, potential energy of said second layer to said first layer, and even numbers, respectively.

20. A light-emitting semiconductor device according to claim 18, wherein said wavelength $\lambda_{TW}$ in said first layer is determined by a formula $\lambda_{TW} = h/[2m_{TW}(E_T+V_T)]^{1/2}$, said wavelength $\lambda_{TB}$ in said second layer is determined by a formula $\lambda_{TB} = h/(2m_{TB}E_T)^{1/}$, said thickness of said first layer $D_{TW}$ is determined by a formula $D_{TW} = n_{TW}\lambda_{TW}/4$, and said thickness of said second layer $D_{TB}$ is determined by a formula $D_{TB} = n_{TB}\lambda_{TB}/4$, where h, $m_{TW}$, $m_{TB}$, $E_T$, $V_T$, and $n_{TW}$ and $n_{TB}$ represent a Plank's constant, effective mass of said carrier in said first layer, effective mass of said carrier in said second layer, kinetic energy of carriers at the level near the lowest energy level in said second layer, potential energy of said second layer to said first layer, and even numbers, respectively.

21. A light-emitting semiconductor device according to claim 17, wherein said quantum-wave interference layer comprises:

a plurality of partial quantum-wave interference layers $I_{Tk}$ with $T_{Tk}$ periods of a pair of said first layer and said second layer being displaced in series by varying k as 1, 2, ..., and

wherein index k of said plurality of said partial quantum-wave interference layers corresponds to index k of kinetic energy level $E_{Tk}+V_T$ and $E_{Tk}$ and said first and second layers have thicknesses of $n_{TWk}\lambda_{TWk}/4$, and $n_{TBk}\lambda_{TBk}/4$, respectively, where $E_{Tk}+V_T$ and $E_{Tk}$, $\lambda_{TWk}$ and $\lambda_{TBk}$, and $n_{TWk}$, $n_{TBk}$ represent kinetic energy level of carriers flowing into respective said first layer and said second layer, wavelength of quantum-wave of carriers flowing into respective said first layer and said second layer, and even numbers, respectively, and $\lambda_{TWk}$ and $\lambda_{TBk}$ are determined by functions of $E_{Tk}+V_T$ and $E_{Tk}$, respectively.

22. A light-emitting semiconductor device according to claim 18, wherein said quantum-wave interference layer comprises:

a plurality of partial quantum-wave interference layers $I_{Tk}$ with $T_{Tk}$ periods of a pair of said first layer and said second layer being displaced in series by varying k as 1, 2, ..., and

wherein index k of said plurality of said partial quantum-wave interference layers correspond to index k of kinetic energy level $E_{Tk}+V_T$ and $E_{Tk}$ and said first and second layers have thicknesses of $n_{TWk}\lambda_{TWk}/4$, and $n_{TBk}\lambda_{TBk}/4$, respectively, where $E_{Tk}+V_T$ and $E_{Tk}$, $\lambda_{TWk}$ and $\lambda_{TBk}$, and $n_{TWk}$, $n_{TBK}$ represent kinetic energy level of carriers flowing into respective said first layer and said second layer, wavelength of quantum-wave of carriers flowing into respective said first layer and said second layer, and even numbers, respectively, and $\lambda_{TWk}$ and $\lambda_{TBk}$ are determined by functions of $E_{Tk}+V_T$ and $E_{Tk}$, respectively.

23. A light-emitting semiconductor device according to claim 17, wherein said quantum-wave interference layer comprises:

a plurality of partial quantum-wave interference layers, each of said partial quantum-wave interference layers having serial pairs of said first layer and said second layer with serial pairs of thicknesses of $(n_{TW1}\lambda_{TW1}/4, n_{TB1}\lambda_{TB1}/4)$, ..., $(n_{TWk}\lambda_{TWk}/4, n_{TBk}\lambda_{TBk}/4)$, ..., $(n_{TWj}\lambda_{TWj}/4, n_{TBj}\lambda_{TBj}/4)$, and

wherein index k in said partial quantum-wave interference layer corresponds to index k of kinetic energy level $E_{Tk}+V_T$ and $E_{Tk}$, and $E_{Tk}+V_T$ and $E_{Tk}$, $\lambda_{TWk}$ and $\lambda_{TBk}$, and $n_{TWk}$, $n_{TBk}$ represent kinetic energy level of carriers flowing into respective said first layer and said second layer, wavelength of quantum-wave of carriers flowing into respective said first layer and said second layer, and even numbers, respectively, and $\lambda_{TWk}$ and $\lambda_{TBk}$ are determined by functions of $E_{Tk}+V_T$ and $E_{Tk}$, respectively.

24. A light-emitting semiconductor device according to claim 18, wherein said quantum-wave interference layer comprises:

a plurality of partial quantum-wave interference layers, each of said partial quantum-wave interference layer having serial pairs of said first layer and said second layer in said first quantum-wave interference layer with serial pairs of thicknesses of $(n_{TW1}\lambda_{TW1}/4, n_{TB1}\lambda_{TB1}/4)$, ..., $(n_{TWk}\lambda_{TWk}/4, n_{TBk}\lambda_{TBk}/4)$, ..., $(n_{Twj}\lambda_{TWj}/4, n_{TBj}\lambda_{TBj}/4)$, and

wherein index k in said partial quantum-wave interference layer corresponds to index k of kinetic energy level $E_{Tk}+V_T$ and $E_{Tk}$, and $E_{Tk}+V_T$ and $E_{Tk}$, $\lambda_{TWk}$ and $\lambda_{TBk}$, and $n_{Twk}$, $n_{TBk}$ represent kinetic energy level of carriers flowing into respective said first layer and said second layer, wavelength of quantum-wave of carriers flowing into respective said first layer and said second layer, and even numbers, respectively, and $\lambda_{TWk}$ and $\lambda_{TBk}$ are determined by functions of $E_{Tk}+V_T$ and $E_{Tk}$, respectively.

25. A light-emitting semiconductor device according to claim 17 comprising:

a $\delta_T$ layer for sharply varying energy band, being formed between said first and said second layers, wherein said $\delta_T$ layer is substantially thinner than that of said first and said second layers.

26. A light-emitting semiconductor device according to claim 18 comprising:

a $\delta_T$ layer for sharply varying energy band, being formed between said first and said second layers, wherein said $\delta_T$ layer is substantially thinner than that of said first and said second layers.

27. A light-emitting semiconductor device according to claim 17, wherein said quantum-wave interference layer functions as a transmission layer for transmitting said carriers.

**28.** A light-emitting semiconductor device according to claim 18, wherein said quantum-wave interference layer functions as a transmission layer for transmitting said carriers.

F I G. 1

F I G. 2

FIG. 3A

FIG. 3B

FIG. 3C

FIG. 3D

FIG. 3E

FIG. 3F

FIG. 3G

FIG. 3H

# FIG. 4

# F I G. 5

FIG. 6A

FIG. 6B

FIG. 6C

FIG. 6D

**FIG. 7A**

Bo | W | B | W | B | W | B

**FIG. 7B**

Bo | W | B | W | B | W | B

**FIG. 7C**

Bo | W | B | W | B | W | B

**FIG. 7D**

Bo | W | B | W | B | W | B

# FIG. 8

100

Au/Zn 19p

| Au/Zn | |
|---|---|

| p-GaAs | 18 |
|---|---|
| p-AlGaAs | 17 |
| electron reflection layer (eR) | 16 |
| emission layer | 15 |
| hole reflection layer (hR) | 14 |
| electron transmission layer (eT) | 13 |
| optical reflection layer | 12 |
| n-GaAs | 11 |
| n-GaAs | 10 |

19n

Au/Ge

FIG. 9

# FIG. 10

200

Au/Zn     31p

| | |
|---|---|
| p-GaAs | — 30 |
| p-GaInP | — 29 |
| hole transmission layer (hT) | — 28 |
| p-AlInP | — 27 |
| electron reflection layer (eR) | — 26 |
| emission layer | — 25 |
| hole reflection layer (hR) | — 24 |
| electron transmission layer (eT) | — 23 |
| optical reflection layer | — 22 |
| n-GaAs / n-GaInP | — 21 |
| n-GaAs | — 20 |
| | — 31n |

Au/Ge